# EUROPEAN PATENT APPLICATION

(11) **EP 0 692 818 A2**
(43) Date of publication of application: **17.01.1996**
(21) Application number: 95109914.2
(22) Date of filing: 26.06.1995
(51) Int. Cl.: H01L 21/306, H01L 21/20

(54) **Oxygen removing method and contaminant removing method usable in semiconductor device fabricating process, and compound semiconductor device fabricating method and apparatus based on both methods**

(30) Priority: 27.06.1994 JP 144604/94
(71) Applicant: CANON KABUSHIKI KAISHA, Tokyo (JP)
(72) Inventor: Uchida, Mamoru, c/o Canon K.K., Ohta-ku, Tokyo (JP)
(74) Representative: Tiedtke, Harro, Dipl.-Ing.

(57) **Abstract**

An oxygen removing method comprises a step of removing oxygen by irradiating an As molecular beam to the semiconductor in hydrogen plasma. A contaminant removing method comprises a first step of removing contaminants principally other than oxygen, and a second step of removing principally oxygen by irradiating an As molecular beam to the semiconductor in hydrogen plasma. A semiconductor device fabricating method comprises, in addition to the above first and second steps, a step of developing growth of a semiconductor layer, wherein transfer passages between the steps are held under vacuum. With these methods, contaminants, particularly oxygen, on various semiconductors are removed without damaging the semiconductors, while ensuring high efficiency and good surface reconstruction.

## Description

### BACKGROUND OF THE INVENTION

### Field of the Invention

The present invention relates to a method of removing contaminants deposited on semiconductors in the manufacture process of semiconductor devices, particularly such as optical integrated circuits, a semiconductor epitaxy method, and an apparatus for carrying out the semiconductor epitaxy method.

### Related Background Art

Process techniques of compound semiconductors, especially growing techniques for optical integrated circuits, are very important. At the present, however, these techniques are much inferior to Si techniques in reliability and versatility. Difficulties in growth of compound semiconductors are attributable to that the following points have not yet been cleared:
1) removal of surface contaminants;
2) stable surface reconstruction;
3) cleaning while leaving finely processed patterns; and
4) removal of damages caused during fine processing.
Among these points, 1) and 2) cause influences upon devices just by ceasing of growth itself, whereas 3) and 4) cause troubles when fine processing such as photolithography is performed on devices after the ceasing of growth. The problem is more complicated by different degrees of influences depending on materials. While GaInAsP/InP, AlGaAs/GaAs and AlGaInP/GaAs are now mainly used for optical devices, the cause maximizing a difficulty in growth is different for each of materials. By way of example, the importance of influences upon GaInAsP/InP is in the order of 2), 3), 1) and 4). This means that it is difficult for GaInAsP/InP to develop growth of InP or GaInAsP again on a GaInAsP layer which has been subjected to fine processing. The reason is coexistence of As and P in the surface. Because these two elements have saturated vapor pressures and boiling points much different from each other, 2), 3) and 1) cannot be achieved in an ideal manner. Also, the importance of influences upon AlGaAs/GaAs is in the order of 1), 4), 3) and 2). For the material containing Al, since Al is apt to be easily oxidized, it is almost impossible to remove an oxide film without damaging wafers once the wafers are taken out into the atmosphere. At the present, there are known applications relating to only extremely limited crystal mixture ratios or device structures (see "Single Longitudinal-Mode Selfaligned (AlGa)As Double Heterostructure Lasers Fabricated by Molecular Beam Epitaxy", Japanese Journal of Applied Physics, Vol. 24, No. 2, L89 to L90 (1985).

As mentioned above, a method of efficiently removing various contaminants on semiconductors without damaging the semiconductors has not yet been known so far. In particular, it has been very difficult to remove oxygen as a contaminant from semiconductors without damaging the semiconductors. For compound semiconductors whose constituent elements have low desorbing temperatures, the substrate temperature cannot be so raised in a contaminant removing step and, therefore, the efficiency of removing contaminants cannot be increased. Although that problem is solved by applying partial pressure for the element having a low desorbing temperature, when the compound semiconductor contains several elements having low separating temperatures, it is hard to simultaneously apply partial pressures for the respective elements. For the reason, the contaminant removing step has faced difficulties in removing contaminants while keeping a desired crystal mixture ratio. With future developments of the band engineering, new combinations of materials (such as AlInP on GaInAsP) will probably be required. It is apparent that the necessity of a cleaning technique covering a wide range will be increased in such future situations.

### SUMMARY OF THE INVENTION

An object of the present invention is to overcome the above-mentioned problems and to provide a method of removing contaminants, particularly oxygen, on semiconductors without damaging the semiconductors, while ensuring high efficiency and good surface reconstruction.

To achieve the above object, the present invention provides, as a method of removing oxygen on a semiconductor, an oxygen removing method comprising a step of removing oxygen by irradiating an As molecular beam to the semiconductor in hydrogen plasma.

Also, the present invention provides, as a method of removing contaminants other than oxygen, such as carbon, a contaminant removing method comprising a first step of removing contaminants principally other than oxygen, and a second step of removing principally oxygen by irradiating an As molecular beam to the semiconductor in hydrogen plasma.

Further, the present invention provides, as a method of fabricating a semiconductor device based on the above methods, a semiconductor device fabricating method comprising a first step of removing contaminants principally other than oxygen, a second step of removing principally oxygen by irradiating an As molecular beam to the semiconductor in hydrogen plasma, and a third step of developing growth of a semiconductor layer, wherein transfer passages between the steps are held under vacuum.

Additionally, the present invention provides a semiconductor layer growing apparatus for carrying out the above semiconductor device fabricating method.

### BRIEF DESCRIPTION OF THE DRAWINGS

Fig. 1 is a schematic view showing one example of configuration of an apparatus for carrying out an oxygen removing method and a contaminant removing method of the present invention.

Fig. 2 is a graph showing an effect of the oxygen removing method of the present invention.

Fig. 3 is a schematic view showing one example of an optical device to which the present invention is applied.

### DESCRIPTION OF THE PREFERRED EMBODIMENTS

### (Embodiment 1)

The method of this embodiment comprises steps below.
Crystal growth 1 → wafer take-out → fine processing (such as formation of mesa and grating) → removal of surface contaminants principally other than oxygen → transfer in vacuum → removal of oxide film → transfer in vacuum → crystal recovery → (return to removal of surface contaminants other than oxygen, if necessary) → transfer in vacuum → crystal growth 2 (repeated growth).

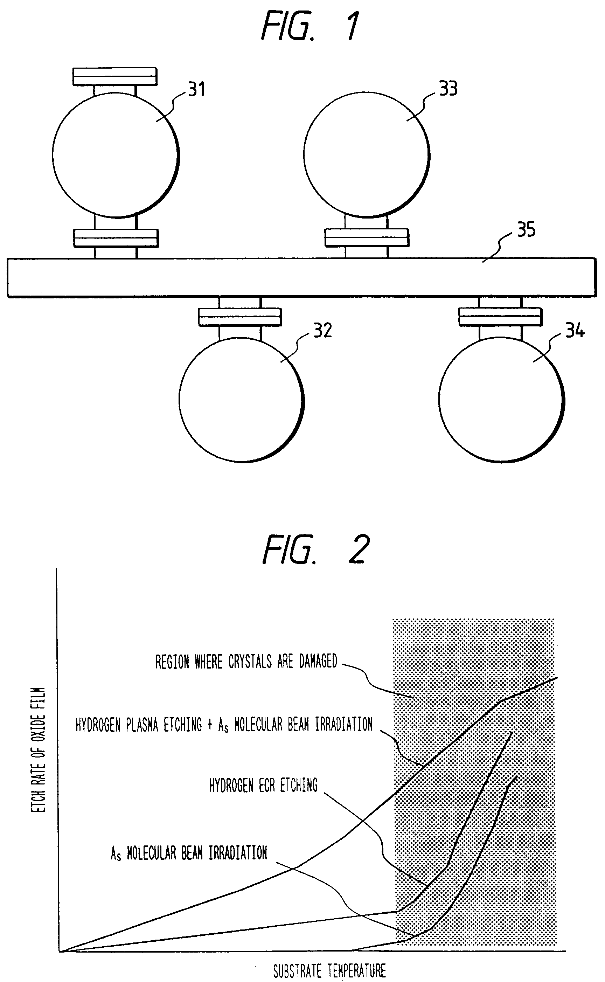

Fig. 1 schematically shows an apparatus for carrying out the method of the present invention. The apparatus comprises a loading/locking chamber 31, a first etching chamber 32 for removing contaminants, chiefly carbon, a second etching chamber 33 for removing an oxide film, 34 is a growing chamber for developing growth again, and a vacuum tunnel 35 for interconnecting the respective chambers.

In the first etching chamber 32, contaminants other than oxygen, chiefly carbon, are removed. This step of removing contaminants principally other than oxygen can be performed by any of generally used processes such as etching. Incidentally, those contaminants can efficiently be removed by using oxygen plasma. The use of oxygen plasma, however, results in a larger amount of taken-in oxygen than before the process.

A wafer is then transferred from the first etching chamber 32 to the second etching chamber 33 through the vacuum tunnel so that an oxide film removing may be performed without exposing the wafer to new contamination sources. This oxide film removing step is the most essential step of the present invention. An effect of removing an oxide film is increased by irradiating an As beam to the wafer as well as hydrogen plasma generally used. Further, since the oxide film removing effect is large even at low temperature, the oxide film removing step can be performed at low temperature. In other words, the oxide film can be removed at temperature lower than the desorbing temperature (about 350°C) and, therefore, damage on crystals is extremely small. Fig. 2 graphically shows the relationship between the etch rate of an oxide film and the substrate temperature for the cases of using hydrogen plasma alone, an As molecular beam alone, and both of them. As seen from the graph, it has been found that, as compared with a sole process of irradiation of an As molecular beam or etching by ECR-excited hydrogen plasma, the oxide film removing ability greater than the sum of respective etch rates is achieved by combining both the processes with each other and, in addition, damage on crystals caused by the combined process is extremely small. Although the detailed mechanism is not yet clear, such advantageous features are presumably attributable to that desorption of oxygen by As is accelerated by H* + H⁺ excited by ECR.

Thus, according to the present invention, it is possible to remove oxygen at low temperature and to hold down damage on semiconductors small. Further, in an additional step, the desorbed element is compensated for by applying heat based on specific heat history under irradiation of a molecular beam. As a result, the crystals can be recovered completely.

In a third step, crystal growth is developed again.

The present invention will be described below in more detail in connection with one application to an optical device.

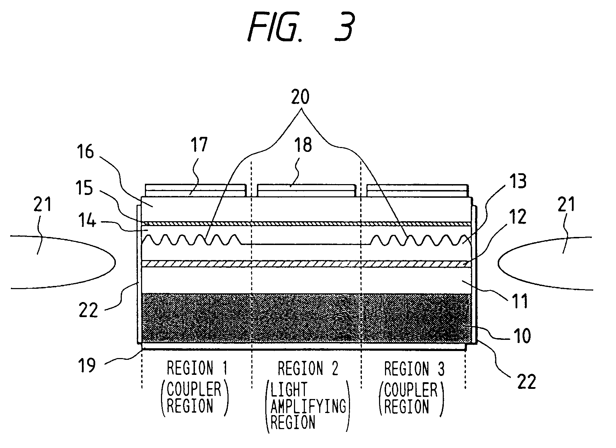

Fig. 3 schematically shows an example of an integrated optical device having ternary or quarternary optical guide layers and a grating.

First of all, on an n-type InP substrate 10, growth of a first clad layer 11 of n-type InP, a first core layer 12 of undoped GaInAsP, and a second clad layer 13 of p-type GaInAsP is developed in this order, followed by formation of a grating 20 thereon. In the last process, a grating pattern is formed by the usual photolithography technique, and then chlorine-based dry etching is performed to form the grating 20 with a depth of 100 nm. Accordingly, carbon remains on the surface after removing the resist.

After that, the contaminant removing method explained above is applied to the processed substrate or wafer. The wafer is first loaded in the loading/locking chamber 31 which is evacuated to a high vacuum level, and then it is transferred through the vacuum tunnel 35 to the first etching chamber 32 in which ECR etching is carried out by using oxygen of high purity. Etching conditions are set to gas pressure of 3.0 × 10⁻³ Torr, ECR power of 100 W, and etching time of 10 minutes. Under these conditions, contaminants chiefly consisted of carbon can be removed without affecting the finely processed pattern. With the ECR etching using oxygen, however, the wafer surface is covered by oxygen in the form of an oxide film.

Next, the wafer is transferred through the vacuum tunnel 35 to the second etching chamber 33 in which hydrogen of high purity is ECR-excited and, under hydrogen plasma, an As molecular beam is irradiated to the wafer using a gas cell, thereby removing the oxide film. Removing conditions are set to gas pressure of 5 × 10⁻⁴ Torr, ECR power of 100 W, substrate temperature of 300°C, arsine flow rate of 2 SCCM, cracking temperature of 900°C, and processing time of 30 minutes.

In the above process, since the substrate temperature is 300°C, i.e., lower than the desorbing temperature of P, P is not much desorbed, but desorbed to some extent. Therefore, the wafer is then transferred through the vacuum tunnel 35 to the growing chamber 34 in which heat treatment (annealing) is performed under irradiation of a P molecular beam. Heat treatment conditions are set to phosphine flow rate of 3 SCCM, cracking temperature of 900°C, substrate temperature of 530°C, and annealing time of 1 hour. The timing to finish the annealing can be determined based on in situ monitoring by RHEED.

If the surface state is not sufficient, the annealing effect can be increased by repeating the above step.

After confirming that the surface has been cleaned, repeated growth of a third clad layer 14 of p-type GaInAsP, a second core layer 15 of GaInAsP, a fourth clad layer 16 of p-type GaInAsP and a cap layer 17 of p-type GaInAsP is developed in this order thereon.

Using the oxygen removing method and the contaminant removing method of the present invention makes it possible to improve a surface state of the semiconductor layer, easily develop repeated epitaxy, and improve quality of the semiconductor layer formed by the repeated epitaxy.

While the substrate temperature in the oxygen removing step is set to 300°C in this embodiment, it may be set to higher temperature, e.g., 400°C, for increasing the removal efficiency. In this case, however, because P becomes more apt to be desorbed from the semiconductor surface, partial pressure of P is applied simultaneously during the oxygen removing step. The partial pressure can be applied by supplying P into the atmosphere, or by irradiating a molecular beam of P to the surface. At this time, it is desired that the substrate temperature be not higher than the desorbing temperature of As which is the second lowest next to that of P among the constituent elements. The reason is that a difficulty in control is encountered when partial pressures are applied for two elements, because which element is coupled to vacant sites in the semiconductor surface is unknown.

### (Embodiment 2)

A description will here be made of an embodiment in which the material is changed from GaInAsP in above Example 1 to AlGaAs. Thus, in Fig. 3, the substrate 10 is an n-type GaAs substrate and the clad layers 11, 13, 14, 16 are all made of AlGaAs. Since this embodiment does not contain P having high vapor pressure, the surface is relatively stably reconstructed. However, because of containing Al, removal of contaminants from AlGaAs is more difficult than from GaInAsP. The present invention is applied to the contaminant removing step performed after forming the grating on the second clad layer 13.

First, to intensify a physical etching mode, a gas mixture of oxygen and argon (partial pressure ratio 9 : 1) is used in the step of removing contaminants other than oxygen, chiefly carbon. Etching conditions are set to gas pressure of 3.0 × 10⁻³ Torr, ECR power of 100 W, and etching time of 10 minutes. These conditions are stronger than those in above Example 1, but are selected so as not to impair crystallinity of finely processed AlGaAs. Next, processing conditions of the oxide film removing step are set to hydrogen gas pressure of 5 × 10⁻⁴ Torr, ECR power of 100 W, substrate temperature of 520°C, arsine flow rate of 2 SCCM, cracking temperature of 900°C, and processing time of 30 minutes. The increased substrate temperature of 520°C is to accelerate desorption of the oxide film. Since P having low desorbing temperature is not contained unlike above Embodiment 1, the substrate temperature can be set to a higher value. In the subsequent crystal recovery step, crystals can be restored to a satisfactory state by holding the wafer at temperature of 560°C for about 2 hours while an As molecular beam is irradiated to the semiconductor surface. Repeated growth of AlGaAs is then performed by epitaxy such as MBE or CBE.

A semiconductor containing Al remarkably increases a difficulty in removal of contaminants, but the contaminants can efficiently be removed by using the oxygen removing method and the contaminant removing method of the present invention.

### (Embodiment 3) AlGaInAsP/AlGaAs

A description will here be made of an embodiment in which the second clad layer in Fig. 3 contains Al, As and P simultaneously, i.e., it is made of AlGaInAsP, AlGaAsP or the like.

In the step of removing contaminants chiefly consisted of carbon, the conditions set in Example 2 are employed to intensify a physical etching mode. On the other hand, since P having low desorbing temperature is contained, the conditions set in Example 1 are employed in the oxide film removing step. The crystal restoring step is performed by employing the conditions set in Example 1.

As set forth above, according to the present invention, removal of contaminants and removal of oxygen can efficiently be achieved at low temperature. Contaminants on even a semiconductor having been subjected to fine processing can be removed without damaging the finely processed pattern. Also, even for a semiconductor, such as GaInAsP, containing a plurality of elements, such as As and P, which have high vapor pressure, i.e., which are apt to be desorbed from the semiconductor surface, contaminants thereon can be removed without affecting the surface crystal structure. Further, even for a semiconductor such as AlGaAs which forms a strong oxide film, the oxide film can be removed by a powerful removing ability. In addition, even for a semiconductor containing not only a plurality of elements which are apt to be desorbed from the semiconductor surface, but also an element such as Al which is responsible for forming a strong oxide film, contaminants thereon can be removed satisfactorily. As a result of efficient removal of contaminants, repeated growth of a semiconductor on the underlying semiconductor layer can easily be developed and a layer formed by the repeated growth can have good quality.

An oxygen removing method comprises a step of removing oxygen by irradiating an As molecular beam to the semiconductor in hydrogen plasma. A contaminant removing method comprises a first step of removing contaminants principally other than oxygen, and a second step of removing principally oxygen by irradiating an As molecular beam to the semiconductor in hydrogen plasma. A semiconductor device fabricating method comprises, in addition to the above first and second steps, a step of developing growth of a semiconductor layer, wherein transfer passages between the steps are held under vacuum. With these methods, contaminants, particularly oxygen, on various semiconductors are removed without damaging the semiconductors, while ensuring high efficiency and good surface reconstruction.

## Claims

1. An oxygen removing method for a semiconductor, comprising:
a step of removing oxygen by irradiating an As molecular beam to said semiconductor in hydrogen plasma.

2. An oxygen removing method according to claim 1, wherein said semiconductor is a compound semiconductor.

3. An oxygen removing method according to claim 2, wherein said compound semiconductor is a compound semiconductor of III-V group mixed crystals.

4. An oxygen removing method according to claim 2 or 3, wherein when removing oxygen, partial pressure is applied for one of elements making up said compound semiconductor that has the lowest desorbing temperature at which the element is allowed to be desorbed from said semiconductor.

5. An oxygen removing method according to claim 4, wherein said element for which the partial pressure is applied is an element other than As.

6. An oxygen removing method according to claim 4 or 5, wherein said element for which the partial pressure is applied is P.

7. An oxygen removing method according to any one of claims 1 to 6, wherein said hydrogen plasma is created by ECR excitation.

8. An oxygen removing method according to any one of claims 1 to 7, wherein said As molecular beam is obtained by cracking hydride of As.

9. An oxygen removing method according to any one of claims 4 to 6, wherein said partial pressure is applied by supplying the element, for which said partial pressure is to be applied, into the atmosphere.

10. An oxygen removing method according to claim 4, wherein said partial pressure is applied by irradiating a molecular beam of the element, for which said partial pressure is to be applied, to said semiconductor.

11. A contaminant removing method for a semiconductor, comprising:
a first step of removing contaminants principally other than oxygen; and
a second step of removing principally oxygen by the oxygen removing method according to any one of claims 1 to 10.

12. A contaminant removing method according to claim 11, wherein said first step and said second step are repeated plural times.

13. A contaminant removing method according to claim 11 or 12, wherein said first step is effected by dry etching employing oxygen or a gas mixture of oxygen and argon.

14. A contaminant removing method according to any one of claims 11 to 13, wherein a transfer passage between said first step and said second step is held under vacuum.

15. A contaminant removing method according to any one of claims 11 to 14, further comprising an additional step of applying heat based on specific heat history under irradiation of a molecular beam of the element which has been desorbed, for crystal recovery.

16. A semiconductor device fabricating method, comprising:
a step of removing contaminants on a surface on which growth of a semiconductor layer is to be developed, according to the contaminant removing method according to any one of claims 11 to 15; and
a step of developing growth of a semiconductor layer;
wherein transfer passages between said steps are held under vacuum.

17. A semiconductor layer growing apparatus for use in the semiconductor device fabricating method according to claim 16, comprising:
means for carrying out said steps; and
means for holding transfer passages between said steps under vacuum.
